(19) Europäisches Patentamt
European Patent Office
Office européen des brevets

(11) **EP 2 312 286 A1**

(12) **EUROPEAN PATENT APPLICATION**
published in accordance with Art. 153(4) EPC

(43) Date of publication:
**20.04.2011 Bulletin 2011/16**

(51) Int Cl.:
*G01J 1/02* (2006.01)  *H01L 27/14* (2006.01)
*H01L 35/32* (2006.01)  *H01L 35/34* (2006.01)

(21) Application number: **09800454.2**

(22) Date of filing: **24.07.2009**

(86) International application number:
**PCT/JP2009/063241**

(87) International publication number:
**WO 2010/010940 (28.01.2010 Gazette 2010/04)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **25.07.2008 JP 2008192751**

(71) Applicant: **Panasonic Electric Works Co., Ltd. Kadoma-shi Osaka 571-8686 (JP)**

(72) Inventors:
• **USHIYAMA, Naoki Kadoma-shi Osaka 571-8686 (JP)**
• **TSUJI, Koji Kadoma-shi Osaka 571-8686 (JP)**

(74) Representative: **Appelt, Christian W. Forrester & Boehmert Pettenkoferstrasse 20-22 80336 München (DE)**

(54) **METHOD FOR MANUFACTURING INFRARED IMAGE SENSOR AND INFRARED IMAGE SENSOR**

(57)     In the method for manufacturing the infrared image sensor, first, a thermal insulation layer (33) is made by forming a silicon dioxide film (31) on a first area (A1) followed by forming a silicon nitride film (32) on the silicon dioxide film (31). The silicon dioxide film (31) has compression stress. The first area (A1) is reserved in a surface of a silicon substrate (1) for forming an infrared detection element (3). The silicon nitride film (32) has tensile stress. Next, a well region (41) is formed in a second area (A2) reserved in the surface of the silicon substrate (1) for forming a MOS transistor (4). After that, a gate insulation film (45) of the MOS transistor (4) is formed by means of thermal oxidation of the surface of the silicon substrate (1). Thereafter, a temperature detection element (36) is formed on the thermal insulation layer **(33)**. Subsequently, a drain region **(43)** and a source region **(44)** of the MOS transistor (4) are formed in the well region (41). Finally, a cavity **(11)** for thermal insulation is formed in a portion of the silicon substrate (1) corresponding to the infrared detection element (3).

*FIG. 1A*

EP 2 312 286 A1

*FIG. 1B*

*FIG. 1C*

## Description

## Technical Field

The present invention is directed to a method for manufacturing an infrared image sensor and an infrared image sensor.

## Background Art

Japanese patent laid-open publication No. 2006-170937 (document 1) discloses an infrared sensor (infrared image sensor) which includes a silicon substrate, and a plurality of cells (so-called pixels) formed on a surface of the silicon substrate. Each of the pixels includes a thermal type infrared detection element configured to detect infrared, and a MOS transistor configured to read out an output of the infrared detection element and arranged adjacent to the infrared detection element. The silicon substrate is provided with cavities for thermal insulation in its portions respectively corresponding to the infrared detection elements of the pixels.

Besides, the aforementioned infrared detection element includes a supporting member, an infrared absorption member, and two beam members. The supporting member is shaped into a rectangular frame shape and is formed on the surface of the silicon substrate. The infrared absorption member is shaped into a rectangular shape and is disposed inside the supporting member. Each of the beam members connects the supporting member to the infrared absorption member.

In order to form the aforementioned infrared detection element, a first silicon dioxide film is formed on the surface of the silicon substrate. Next, a second silicon dioxide film is formed on the first silicon dioxide film. Thereafter, a temperature detection element (e.g., thermopile, and thermocouple) is formed on the second silicon dioxide film. Subsequently, a third silicon dioxide film is formed over the second silicon dioxide film to cover the thermopile.

The infrared detection element is formed by patterning a laminate composed of the first silicon dioxide film, the second silicon dioxide film, the temperature detection element, and the third silicon dioxide film.

In the above document 1, in a process of forming the MOS transistor, a warp of the infrared detection element may occur when a residual stress of the infrared detection element is changed. In this instance, the infrared detection element may have a poor stability regarding its configuration, and have a poor sensitivity.

Besides, in order to improve the sensitivity of the infrared image sensor disclosed in the above document 1, it is required to increase a temperature variation caused by infrared absorption. For example, to thin each beam member for decreasing thermal conductance thereof is proposed.

However, the infrared absorption member and each beam member of the infrared detection element are made of silicon dioxide films (the first to third silicon dioxide films). Therefore, the beam member is likely to be deformed, thereby warped.

## Disclosure of Invention

In view of the above insufficiency, the present invention has been aimed to propose a method of manufacturing an infrared image sensor and an image sensor which is capable of making infrared detection elements thin, yet keeping them free from warp.

An infrared image sensor manufactured by the method for manufacturing an infrared image sensor in accordance with the present invention includes a silicon substrate, and a plurality of cells formed over a surface of the silicon substrate. Each of the cells includes an infrared detection element configured to detect an infrared, and a MOS transistor configured to read out an output of the infrared detection element, the MOS transistor being arranged adjacent to the infrared detection element. The silicon substrate is provided with cavities for thermal insulation in its portions respectively corresponding to the infrared detection elements of the cells. Each of the infrared detection elements includes a thermal insulation layer formed over the surface of the silicon substrate, and a temperature detection element formed on the thermal insulation layer. The thermal insulation layer includes a silicon dioxide film for thermal insulation formed on the surface of the silicon substrate, and a silicon nitride film for thermal insulation formed on the silicon dioxide film, the silicon dioxide film having compression stress, and the silicon nitride film having tensile stress. The temperature detection element is configured to absorb infrared and detect temperature change resulting form infrared absorption. The MOS transistor including a well region of a first conductivity type formed in the surface of the silicon substrate, a drain region of a second conductivity type formed in the well region, a source region of the second conductivity type formed in the well region so as to be away from the drain region, and a gate insulation film formed on a part of the well region formed between the drain region and the source region.

The method for manufacturing the infrared image sensor includes a thermal insulation layer forming step, a well region forming step, a gate insulation film forming step, a temperature detection element forming step, a drain region and source region forming step, and a cavity forming step. The thermal insulation layer forming step is defined as a step of forming the thermal insulation layer over a first area of the surface of the silicon substrate. The well region forming step is defined as a step of forming the well region formed in a second area of the surface of the silicon substrate after the thermal insulation layer forming step. The gate insulation film forming step is defined as a step of forming the gate insulation film by means of thermal oxidation of the surface of the silicon substrate after the well region forming step. The temperature detection element forming step is defined as a step of forming the temperature detection element after the gate insulation film forming step. The drain region and source region forming step is defined as a step of forming the drain region and the source region after the temperature detection element forming step. The cavity forming step is defined as a step of forming the cavity after the drain region and source region forming step.

According to the present invention, the thermal insulation layer is completed by forming the silicon nitride film on the silicon dioxide film prior to formation of the MOS transistor. This silicon nitride film is hard to be oxidized. Therefore, it is possible to prevent the surface of the thermal insulation layer from being thermally oxidized during formation of the MOS transistor (formation of the well region, the gate insulation film, the drain region, and the source region). Accordingly, the thermal insulation layer can be free from change in at least one of the film thickness and the film configuration. Further, the thermal insulation layer is completed by forming the silicon nitride film having tensile stress on the silicon dioxide film having compression stress. Therefore, it is possible to provide the infrared image sensor which is capable of making infrared detection elements thin, yet keeping them free from warp.

In a preferred aspect, the method for manufacturing the infrared image sensor further includes an interlayer dielectric film forming step of forming an interlayer dielectric film over the surface of the silicon substrate by depositing a BPSG film over the surface of the silicon substrate followed by reflowing the deposited BPSG film, after the drain region and source region forming step and before the cavity forming layer. The method further includes a metal line forming step of forming a metal line electrically connecting the temperature detection element with the MOS transistor, after the interlayer dielectric film forming step and before cavity forming step. Moreover, the method includes a passivation film forming step of forming a passivation film on the interlayer dielectric film, after the metal line forming step and before the cavity forming step.

With this preferred aspect, the interlayer dielectric film can have an improved flatness. Therefore, it is possible to avoid breakage of the metal line due to an excess thermal stress or the like.

In a more preferred aspect, the method for manufacturing the infrared image sensor includes a recess forming step of forming a recess, after the well region forming step and before the interlayer dielectric film forming step. The well region forming step includes a step of forming a thermally-oxidized film on the second area so as to be adjacent to the thermal insulation layer. The recess forming step includes a step of forming, at a border between the thermal insulation layer and the thermally-oxidized film, the recess having a depth of the recess which is small relative to a height difference between the thermal insulation layer and the thermally-oxidized film.

With this preferred aspect, the interlayer dielectric film can have a more improved flatness. Therefore, it is possible to successfully avoid breakage of the metal line due to an excess thermal stress or the like.

In another preferred aspect, the method further includes a step of forming the infrared detection element to satisfy following two formulae:

[Formula 1]

$$\int_{-1/2}^{1/2} \sigma_m(y)\,dy = 0$$

[Formula 2]

$$\int_{-1/2}^{1/2} \sigma_m(y)\cdot y\,dy = 0$$

wherein y denotes a distance from a center of the infrared detection element along a direction aligned with a thickness direction of the infrared detection element, and $s_m(y)$ denotes a stress of the infrared detection element, and t denotes a thickness of the infrared detection element.

With this preferred aspect, it is possible to reduce residual stress of the infrared detection element down to zero, and to reduce a bending moment of the infrared detection element down to zero. Therefore, it is possible to keep the infrared detection element free from a warp.

In another preferred aspect, the method for manufacturing the infrared image sensor further comprising a step of keeping a temperature of the silicon dioxide film less than a temperature required for forming the silicon dioxide film and of keeping a temperature of the silicon nitride film less than a temperature required for forming the silicon nitride film, after the thermal insulation layer forming step.

With this preferred aspect, it is possible to protect the film thicknesses and stresses of each of the silicon dioxide film and the silicon nitride film from undesired effect caused by a process temperature of a step performed after the thermal insulation layer forming step. Consequently, it is possible to successfully prevent occurrence of a warp of the infrared detection element.

The infrared image sensor in accordance with the present invention includes a silicon substrate, a plurality of cells formed over a surface of the silicon substrate. Each of the cells includes an infrared detection element configured to detect an infrared, and a MOS transistor configured to read out an output of the infrared detection element, the MOS transistor being arranged adjacent to the infrared detection element. The silicon substrate is provided with cavities for thermal insulation in its portions respectively corresponding to the infrared detection elements of the cells. Each of the infrared detection elements includes a thermal insulation layer formed over the surface of the silicon substrate, and a temperature detection element formed on the thermal insulation layer. The thermal insulation layer includes a silicon dioxide film for thermal insulation formed on the surface of the silicon substrate, and a silicon nitride film for thermal insulation formed on the silicon dioxide film, the silicon dioxide film having compression stress, and the silicon nitride film having tensile stress. The temperature detection element is configured to absorb infrared and detect temperature change resulting form infrared absorption. The MOS transistor includes a well region of a first conductivity type formed in the surface of the silicon substrate, a drain region of a second conductivity type formed in the well region, a source region of the second conductivity type formed in the well region so as to be away from the drain region, and a gate insulation film formed on a part of the well region formed between the drain region and the source region. The silicon nitride film is formed not to be overlapped with the well region in its thickness direction.

According to the present invention, the thermal insulation layer is completed by forming the silicon nitride film having tensile stress on the silicon dioxide film having compression stress. Therefore, even if the MOS transistor is formed by use of a common method, it is possible to prevent a warp of the infrared detection element yet thinning the infrared detection element. In addition, the silicon nitride film is hard to be oxidized. Consequently, with completing the thermal insulation layer by forming the silicon nitride film on the silicon dioxide film prior to formation of the MOS transistor, it is possible to prevent the thermal insulation layer from being thermally oxidized when the MOS transistor is formed. Thus, it is possible to prevent the thermal insulation layer from being changed in at least one of the film thickness and the film configuration.

In a preferred aspect, the infrared image sensor includes a thermally-oxidized film formed over the surface of the silicon substrate so as to be adjacent to the thermal insulation layer, an interlayer dielectric film formed over the surface of the silicon substrate so as to cover a border between the thermal insulation layer and the thermally-oxidized film, and a metal line formed on the interlayer dielectric film so as to connect the temperature detection element with the MOS transistor. The interlayer dielectric film is formed by means of reflowing a BPSG film deposited over the surface of the silicon substrate.

With this preferred aspect, the interlayer dielectric film can have an improved flatness. Therefore, it is possible to avoid breakage of the metal line due to an excess thermal stress or the like.

In another preferred aspect, the infrared image sensor includes a thermally-oxidized film formed over the surface of the silicon substrate so as to be adjacent to the thermal insulation layer, a recess formed at a border between the thermal insulation layer and the thermally-oxidized film, an interlayer dielectric film formed over the surface of the silicon substrate so as to cover the recess, and a metal line formed on the interlayer dielectric film so as to connect the temperature detection element with the MOS transistor. The interlayer dielectric film is formed by means of reflowing a BPSG film deposited over the surface of the silicon substrate.

With this preferred aspect, the interlayer dielectric film can have a more improved flatness. Therefore, it is possible to successfully avoid breakage of the metal line due to an excess thermal stress or the like.

**Brief Description of Drawings**

FIG. 1A is a schematic plain view illustrating an infrared image sensor of the first embodiment,
FIG. 1B is a schematic plain view illustrating a cell of the infrared image sensor of the first embodiment,
FIG. 1C shows a schematic cross sectional view of the infrared image sensor of the first embodiment along the line A-A' of FIG. 1B,
FIG. 2 is a circuit view illustrating the above infrared image sensor,

FIG. 3A is a schematic cross sectional view illustrating a method for manufacturing the above infrared image sensor,

FIG. 3B is a schematic cross sectional view illustrating the method for manufacturing the above infrared image sensor,

FIG. 3C is a schematic cross sectional view illustrating the method for manufacturing the above infrared image sensor,

FIG. 4A is a schematic cross sectional view illustrating the method for manufacturing the above infrared image sensor,

FIG. 4B is a schematic cross sectional view illustrating the method for manufacturing the above infrared image sensor,

FIG. 4C is a schematic cross sectional view illustrating the method for manufacturing the above infrared image sensor,

FIG. 5A is a schematic cross sectional view illustrating the method for manufacturing the above infrared image sensor,

FIG. 5B is a schematic cross sectional view illustrating the method for manufacturing the above infrared image sensor,

FIG. 6A is an explanatory view illustrating the method for manufacturing the above infrared image sensor,

FIG. 6B is an explanatory view illustrating the method for manufacturing the above infrared image sensor,

FIG. 7A is a schematic cross sectional view illustrating the method for manufacturing the above infrared image sensor,

FIG. 7B is a schematic cross sectional view illustrating the method for manufacturing the above infrared image sensor,

FIG. 7C is a schematic cross sectional view illustrating the method for manufacturing the above infrared image sensor,

FIG. 7D is a schematic cross sectional view illustrating the method for manufacturing the above infrared image sensor,

FIG. 8 is a schematic cross sectional view illustrating a method for manufacturing the above infrared image sensor according to the second embodiment,

FIG. 9A is a schematic cross sectional view illustrating the method for manufacturing the above infrared image sensor,

FIG. 9B is a schematic cross sectional view illustrating the method for manufacturing the above infrared image sensor,

FIG. 9C is a schematic cross sectional view illustrating the method for manufacturing the above infrared image sensor, and

FIG. 9D is a schematic cross sectional view illustrating the method for manufacturing the above infrared image sensor.

**Best Mode for Carrying Out the Invention**

**(FIRST EMBODIMENT)**

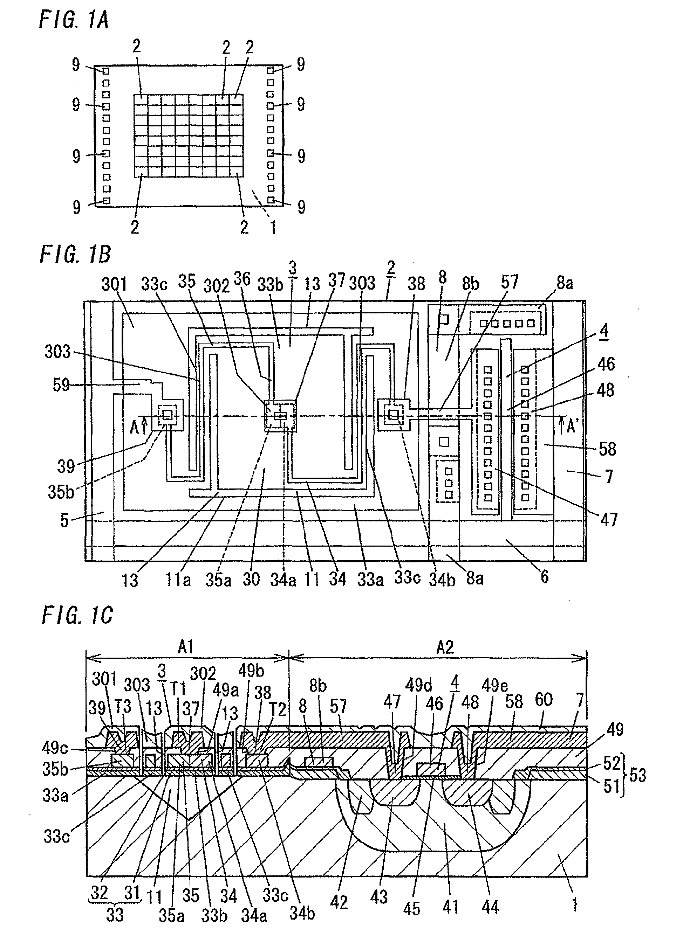

As shown in FIGS. 1A to 1C, an infrared image sensor of the first embodiment includes a silicon substrate **1,** and a plurality of cells (pixels) **2** formed on a surface (upper surface, in FIG. 1 C) of the silicon substrate **1.**

Each of the cells **2** includes a thermal type infrared detection element **3** configured to detect infrared, and a MOS **transistor 4** placed adjacent to the infrared detection element **3.** The MOS transistor **4** is a switching element for pixel selection, which is configured to read out an output of the infrared detection element **3.** The plural cells **2** are arranged on the surface of the silicon substrate 1 in a two dimensional array (matrix) manner. Besides, in the present embodiment, m x n (8 x 8, in the illustrated instance) cells **2** are formed on the surface of the single silicon substrate **1.** The number and/or arrangement of the cells **2** is not limited to the present embodiment.

The silicon substrate **1** is provided with cavities **11** for thermal insulation in its portions respectively corresponding to the infrared detection elements **3** of the cells **2.** In the present embodiment, the silicon substrate **1** is selected such that a conductivity type is n type and that the surface is a (100) surface. The surface of the silicon substrate 1 includes a first area **A1** for forming the infrared detection element **3,** and a second area **A2** for forming the MOS transistor.

The infrared detection element **3** is formed on the first area (area reserved for forming the infrared detection element **3) A1** of the surface of the silicon substrate **1.** The infrared detection element **3** includes a supporting member 301, an infrared absorption member **302,** and a plurality (two, in the present embodiment) of beam members **303.** The supporting portion **301** is formed on the surface of the silicon substrate **1.** The supporting member **301** is shaped into a rectangular frame shape. The infrared absorption member **302** is disposed inside the supporting member **301.** The infrared absorption member **302** is shaped into a rectangular shape. The beam member **303** connects the supporting member **301** to the infrared absorption member **302.** Each of the beam members **303** is shaped into a planar shape extending from a first longitudinal end of a side edge of the infrared absorption member **302** along a direction perpendicular to the side edge and further extending along a direction from the first longitudinal end of the side edge to a second longitudinal end thereof. The beam members **303** are arranged in a rotation symmetry manner with respect to a center axis along a thickness direction of the infrared absorption member **302.**

The infrared detection element **3** (a structure including the infrared absorption member **302,** the beam members **303,** and the supporting member **301)** is formed by patterning a laminate which includes a thermal insulation layer **33** formed on the surface of the silicon substrate 1, a temperature detection element **36** formed on the thermal insulation layer **33,** an interlayer dielectric film **49** formed over the thermal insulation layer **33** to cover the temperature detection element **36,** and a passivation film **60** formed on the interlayer dielectric film **49.**

The thermal insulation layer **33** includes a silicon dioxide film **31** for thermal insulation formed on the surface of the silicon substrate **1** with having compression stress, and a silicon nitride film **32** for thermal insulation formed on the silicon dioxide film **31** with having tensile stress. The thermal insulation layer **33** has a first portion **33a** corresponding to the supporting member **301,** a second portion **33b** corresponding to the infrared absorption member **302,** and third potions **33c** respectively corresponding to the beam members **303.**

The interlayer dielectric film **49** is made of a BPSG film. The passivation film **60** is a laminated film comprising a PSG film formed on the interlayer dielectric film 49 and an NSG film formed on the PSG film. Besides, the passivation film **60** and the interlayer dielectric film **49** are formed over the first area **A1** and the second area **A2.** Each of the passivation film **60** and the interlayer dielectric film **49** has its portion which is formed over the first area **A1** and functions as an infrared absorption film.

The temperature detection element **36** is configured to absorb infrared and detect a temperature variation which is caused by infrared absorption. In the present embodiment, the temperature detection element **36** is a thermocouple made of an n-type polysilicon layer **34** and a p-type polysilicon layer **35.** The temperature detection element **36** may be a thermopile.

Each of the polysilicon layers **34** and **35** are formed on the thermal insulation layer **33.**

Each of the polysilicon layers **34** and **35** has a planar configuration of meander shape, as shown in FIG. 1B. The polysilicon layer **34** is disposed over the second portion **33a,** one of the third portions **33c** (right third portion **33c,** in FIG. 1B), and the first portion **33a.** The polysilicon layer **35** is disposed over the second portion **33a,** the other of the third portions **33c** (left third portion **33c,** in FIG. 1 B), and the first portion **33a.** The n-type polysilicon layer **34** has a first end **34a,** and the p-type polysilicon layer **35** has a first end **35a.** The first ends **34a** and **35a** contact with each other on a center of the second portion **33b** of the thermal insulation layer **33.** The n-type polysilicon layer **34** has a second end **34b,** and the p-type polysilicon layer **35** has a second end **35b.** The second ends **34b** and **35b** are disposed on the first portion **33a** of the thermal insulation layer **33.**

Moreover, the infrared detection element **3** includes electrodes **37** to **39** formed on the temperature detection element **36.**

The electrode (first electrode) **37** is formed on the first ends **34a** and **35a** to extend from the first end **34a** to the first end **35a.** In addition, the first electrode **37** is electrically connected to the first ends **34a** and **35a** of the polysilicon layers **34** and **35** via a contact hole **49a** formed in the interlayer dielectric film **49.** The first electrode **37** is made of a metal (e.g., Al-Si). The first end **34a** of the polysilicon **34,** the first end **35a** of the polysilicon **35,** and the first electrode **37** constitute a hot junction **T1.**

The electrode (second electrode) **38** is formed on the second end **34b** of the polysilicon layer **34.** The second electrode **38** is electrically connected to the second end **34b** of the polysilicon layers **34** via a contact hole **49b** formed in the interlayer dielectric film **49.** The second end **34b** of the n-type polysilicon **34** and the second electrode **38** constitute a first cold junction **T2.**

The electrode (third electrode) **39** is formed on the second end **35b** of the polysilicon layer **35.** The third electrode **39** is electrically connected to the second end **35b** of the polysilicon layers **35** via a contact hole **49c** formed in the interlayer dielectric film **49.** The second end **35b** of the p-type polysilicon **35** and the third electrode **39** constitute a second cold junction **T3.**

Each of the electrodes **37** to **39** is electrically insulated and separated from the other electrodes by the interlayer dielectric film **49.**

The MOS transistor **4** is formed on the second area (area reserved for forming the MOS transistor 4) **A2** of the surface of the silicon substrate **1.**

The MOS transistor **4** includes a well region **41** of a first conductivity type ($p^+$-type, in the present embodiment), a drain region **43** of a second conductivity type ($n^+$-type, in the present embodiment), a source region **44** of the second conductivity type, a channel-stopper region **42** of the $p^{++}$-type, a gate insulation film **45,** a gate electrode **46,** a drain electrode **47,** and a source electrode **48.**

The well region **41** is formed on the surface of the silicon substrate **1.**

The drain region **43** and the source region **44** are formed in the well region **41** to be away from each other.

The channel-stopper region **42** is formed in the well region **41** to surround both the drain region **43** and the source region **44.**

The gate insulation film **45** is formed on a part of the well region **41** formed between the drain region **43** and the source region **44.** The gate insulation film **45** is made of a silicon dioxide film (thermally-oxidized film).

The gate electrode **46** is formed on the gate insulation film **45.** The gate electrode **46** is made of a polysilicon layer.

The drain electrode **47** is formed over the drain region **43.** The drain electrode **47** is electrically connected to the drain region **43** via a contact hole **49d** formed in the interlayer dielectric film **49.**

The source electrode **48** is formed over the source region **44.** The source electrode **48** is electrically connected to the source region **44** via a contact hole **49e** formed in the interlayer dielectric film **49.**

The interlayer dielectric film **49** isolates and separates the gate electrode **46,** the drain electrode **47,** and the source electrode **48** from the others.

Besides, in the present embodiment, the first conductivity type is defined as the p-type, and the second conductivity type is defined as the n-type. In contrast, the first conductivity type may be defined as the n-type, and the second conductivity type may be defined as the p-type.

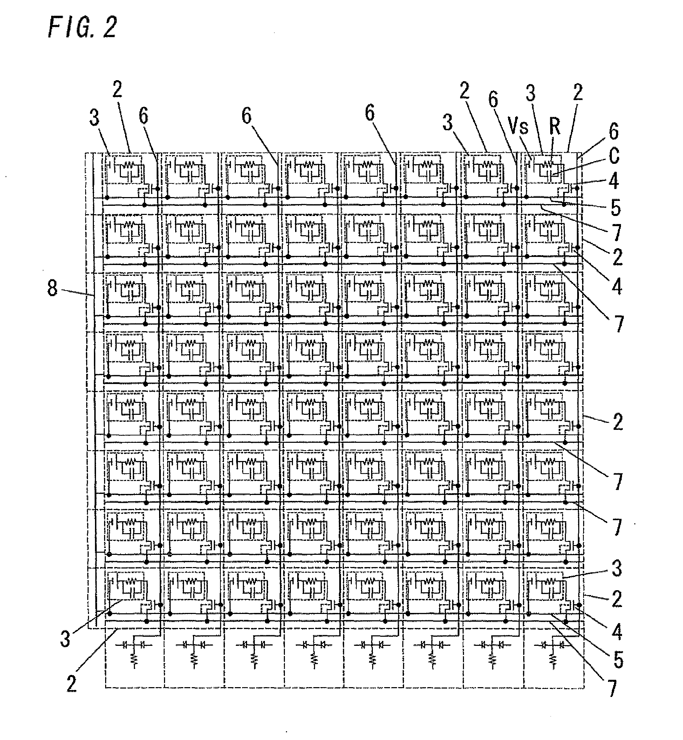

As shown in FIG. 2, the infrared image sensor of the present embodiment includes a plurality of vertical read-out lines **7,** a plurality of horizontal signal lines **6,** and a plurality of reference bias lines **5.** Each of the vertical read-out lines 7 is connected to first ends of the temperature detection elements **36** of the infrared detection elements **3** in each row via the MOS transistors **4.** Each of the horizontal signal lines **6** is connected to the MOS transistors **4** corresponding to the infrared detection elements **36** in each column. Each of the reference bias lines **5** is connected to second ends of the temperature detection elements **36** of the infrared detection elements **3** in each row.

Especially, in the present embodiment, the MOS transistor **4** has its gate electrode **46** connected to the horizontal signal line **6.** Further, the drain electrode **47** is connected to the reference bias line **5** through the temperature detection element **36.** Moreover, the source electrode **48** is connected to the vertical read-out line **7.**

Each reference bias line **5,** each horizontal signal line **6,** each vertical read-out line **7,** and a common ground line **8** are electrically connected to corresponding pads **9,** respectively.

Accordingly, by controlling potentials of the pads **9** to sequentially turn on the MOS transistors **4,** it is enabled to read out a time-series data of the outputs from the infrared detection elements **3.** Besides, in FIG. 2, the temperature detection element **36** is illustrated as its equivalent circuit including a voltage source **Vs** corresponding to thermal electromotive force of the temperature detection element **36,** a resistor **R** connected in series with the voltage source **Vs,** and a capacitor **C** connected in parallel with the resistor **R.**

In each cell 2 of the infrared image sensor of the present embodiment, the MOS transistor **4** has its drain electrode **47** connected to the second electrode **38** by use of a metal line (e.g., Al-Si line) **57.** The drain electrode **47,** the second electrode **38,** and the metal line **57** are formed integrally with each other. The third electrode **39** is electrically connected to the reference bias line **5** by use of a metal line (e.g., Al-Si line) **59.** The third electrode **39,** the reference bias line **5,** and the metal line **59** are formed integrally with each other. The MOS transistor **4** has its source electrode **48** connected to the vertical read-out line 7 by use of a metal line (e.g., Al-Si line) **58.** The source electrode **48,** the vertical read-out line **7,** and the metal line **58** are formed integrally with each other. The gate electrode **46** is electrically connected to the horizontal signal line **6** which is a polysilicon line. The gate electrode **46** and the horizontal signal line **6** are formed integrally with each other.

In addition, as shown in FIGS. 1B and 1C, the channel-stopper region **42** is electrically connected to the common ground line **8.** The common ground line **8** is used to give lower potential to the channel-stopper region **42** than (that given) to the drain region **43** and the source region **44** for mutual isolation of the elements (for isolating the element from each other). The common ground line **8** is composed of a metal line **8a** and a polysilicon line **8b.**

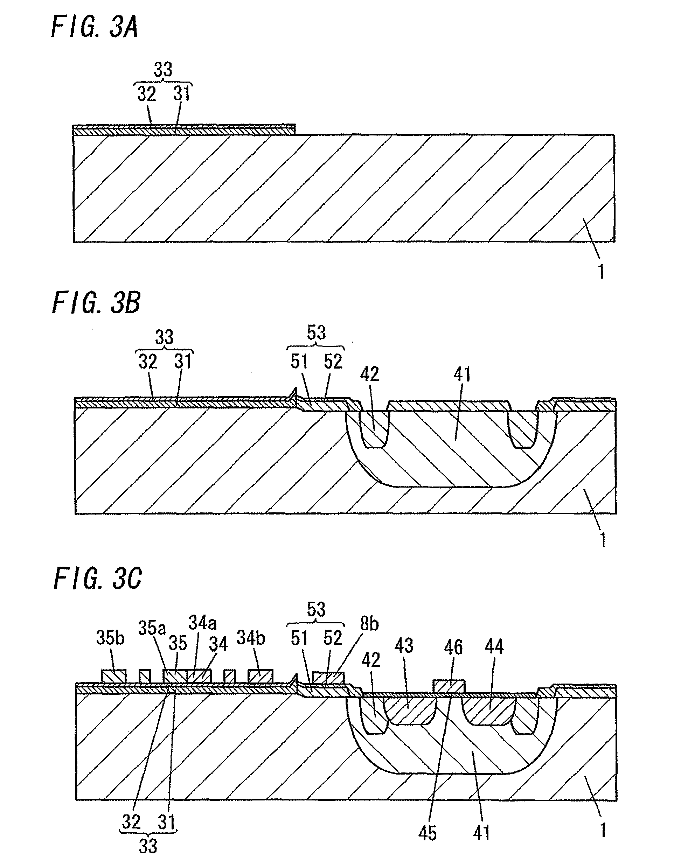

Next, with regard to FIGS. 3 to 5, an explanation is made to a method for manufacturing the infrared image sensor in accordance with the present embodiment.

The method for manufacturing the infrared image sensor of the present embodiment mainly includes a thermal insulation layer forming step, a well region forming step, a gate insulation film forming step, a temperature detection element forming step, a drain region and source region forming step, an interlayer dielectric film forming step, a metal line forming step, a passivation film forming step, and a cavity forming step.

The thermal insulation layer forming step is defined to form the thermal insulation layer **33** on the surface of the silicon substrate **1,** thereby providing a structure illustrated in FIG. 3A. In the thermal insulation layer forming step, the thermal insulation layer **33** is formed on the whole of the surface of the silicon substrate **1.** The thermal insulation layer **33** comprises the silicon dioxide film **31** having a first predetermined film thickness (e.g., 5000 Å) and the silicon nitride film **32** having a second predetermined film thickness (e.g., 2450 Å). For example, the silicon substrate **1** is thermally oxidized at a predetermined temperature (e.g., 1100 deg C) to form the silicon dioxide film **31.** The silicon dioxide film **31** formed in the above mentioned manner has residual stress of -400 MPa. That is, the silicon dioxide film **31** has compression stress (residual compression stress). Next, the silicon nitride film **32** is deposited by LPCVD technique and then is annealed at a predetermined anneal temperature (e.g., 1100 deg C) in $N_2$ gas atmosphere. Thereby, the silicon nitride film **32** is formed. The silicon nitride film **32** formed in the above mentioned manner has residual stress of 1.4 GPa. That is, the silicon nitride film **32** has tensile stress (residual tensile stress). Thereafter, by use of the photolithography technique and the etching technique, a part of the thermal insulation layer **33** formed on the second area **A2** is removed yet a part of the thermal insulation layer **33** formed on the first area **A1** remains.

The well region forming step is performed after the thermal insulation layer forming step. The well region forming step is defined to form the well region **41** in the surface of the silicon substrate **1.** Subsequently, the channel-stopper region forming step is performed. The channel-stopper forming step is defined to form the channel-stopper region **42** in the well region **41** from the surface of the silicon substrate **1.**

The well region forming step is defined to thermally oxidize an exposed area of the surface of the silicon substrate **1** at a predetermined temperature to form a silicon dioxide film **51** on a desired area of the surface of the silicon substrate **1.** Thereafter, the silicon dioxide film **51** is patterned by use of the photolithography technique and the etching technique together with a mask for forming the well region **41.** Subsequently, the well region **41** of the $p^+$-type is formed by means of the ion implantation of a p-type impurity (e.g., boron) followed by the drive-in diffusion (diffusion of impurities).

In the present embodiment, the silicon dioxide film **51** is formed by use of the thermal oxidization technique.

Therefore, the silicon dioxide film **51** is not formed on the first area **A1** of the surface of the silicon substrate **1.** Further, in the well region forming step, the thermal oxidization and the drive-in diffusion are performed at a temperature which does not exceed both a temperature required for forming the silicon dioxide film **31** and a temperature required for forming the silicon nitride film **32,** that is, a temperature of formation of the thermal insulation layer 33 (1100 deg C, in the present embodiment). In other words, the temperature of formation of the thermal insulation layer 33 is selected to exceed a process temperature of the well region forming step. Consequently, the thermal insulation layer 33 sees no substantial change in its residual stress.

The channel-stopper forming step is defined to thermally oxidize the surface of the silicon substrate **1** at a predetermined temperature to form a silicon dioxide film **52** on a desired area of the surface of the silicon substrate **1.** Thereafter, the silicon dioxide film **52** is patterned by use of the photolithography technique and the etching technique together with a mask for forming the channel-stopper region **42.** Subsequently, the channel-stopper region **42** of the p++-type is formed by means of the ion implantation of a p-type impurity (e.g., boron) followed by the drive-in diffusion.

In the present embodiment, the silicon dioxide film **52** is formed by use of the thermal oxidization technique. Therefore, the silicon dioxide film **52** is not formed on the first area **A1** of the surface of the silicon substrate **1.** Further, the thermal oxidization and the drive-in diffusion in the channel-stopper region forming step are performed at a temperature which does not exceed the temperature of formation of the thermal insulation layer **33** (1100 deg C, in the present embodiment). Consequently, the thermal insulation layer **33** sees no substantial change in its residual stress.

The gate insulation film forming step, the temperature detection element forming step, a gate/source/drain forming step (the aforementioned drain region and source region forming step) are performed in this order after the channel-stopper region forming step. Thereby, a structure illustrated in FIG. 3C is obtained.

The gate insulation film forming step is defined to form the gate insulation film **45** made of a silicon dioxide film (thermally-oxidized film) on the surface of the silicon substrate **1** by means of the thermal oxidization.

The temperature detection element forming step is defined to form the temperature detection element 36 on the thermal insulation layer **33.** The temperature detection element forming step includes a polysilicon layer forming step, a polysilicon layer patterning step, a p-type polysilicon layer forming step, and an n-type polysilicon layer forming step. The polysilicon layer patterning step is performed after the polysilicon layer forming step. The p-type polysilicon layer forming step is performed after the polysilicon layer patterning step. The n-type polysilicon layer forming step is performed after the p-type polysilicon layer forming step.

The polysilicon layer forming step is defined to form a non-doped polysilicon layer having a predetermined film thickness (e.g., 3000 Å) on the whole of the surface of the silicon substrate 1 by use of LPCVD technique. The non-doped polysilicon layer is used as a base for forming the gate electrode **46,** the polysilicon line **8b,** the horizontal signal lines **6,** the n-type polysilicon layer **34,** and the p-type polysilicon layer **35.**

In the polysilicon patterning step, by use of the photolithography technique and the etching technique, the non-doped polysilicon layer is patterned in order to leave portions thereof respectively corresponding to the gate electrode **46,** the polysilicon line **8b,** the horizontal signal lines **6,** and the polysilicon layers **34** and **35.**

The p-type polysilicon layer forming step is defined to perform the ion implantation of a p-type impurity (e.g., BF) to a portion of the non-doped polysilicon layer corresponding to the p-type polysilicon layer **35,** followed by the drive diffusion, thereby forming the p-type polysilicon layer **35.** The p-type polysilicon layer **35** has residual stress of -300 MPa.

The n-type polysilicon layer forming step is defined to perform the ion implantation of an n-type impurity (e.g., phosphors) to a portion of the non-doped polysilicon layer corresponding to the n-type polysilicon layer **34,** followed by the drive diffusion, thereby forming the n-type polysilicon layer **34.** The n-type polysilicon layer **34** has residual stress of -300 MPa.

The gate/source/drain forming step is defined to perform the ion implantation of an n-type impurity (e.g., phosphors) to portions of the non-doped polysilicon layer respectively corresponding to the gate electrode **46,** the polysilicon line **8b,** and the horizontal signal lines **6** together with regions of the well region **41** respectively reserved for forming the drain region **43** and the source region **44.** After that, the drive diffusion is performed to form the gate electrode **46,** the polysilicon line **8b,** the horizontal signal lines **6,** the drain region **43,** and the source region **44.** Besides, in the gate/source/drain forming step, a part of the non-doped polysilicon layer to be the gate electrode **46** acts as a mask which prevents the n-type impurity from being implanted to a region below the gate electrode **46** during the ion implantation. That is, in the gate/source/drain forming step, the drain region **43** and the source region **44** are formed by use of the known self alignment technique.

In the present embodiment, process temperatures of each of the steps (the gate insulation film forming step, the polysilicon layer forming step, the polysilicon layer patterning step, the p-type polysilicon layer forming step, the n-type polysilicon layer forming step, the gate/source/drain forming step) are selected not to exceed the temperature of formation of the thermal insulation layer **33** (1100 deg C, in the present embodiment). Consequently, the thermal insulation layer **33** sees no substantial change in its residual stress.

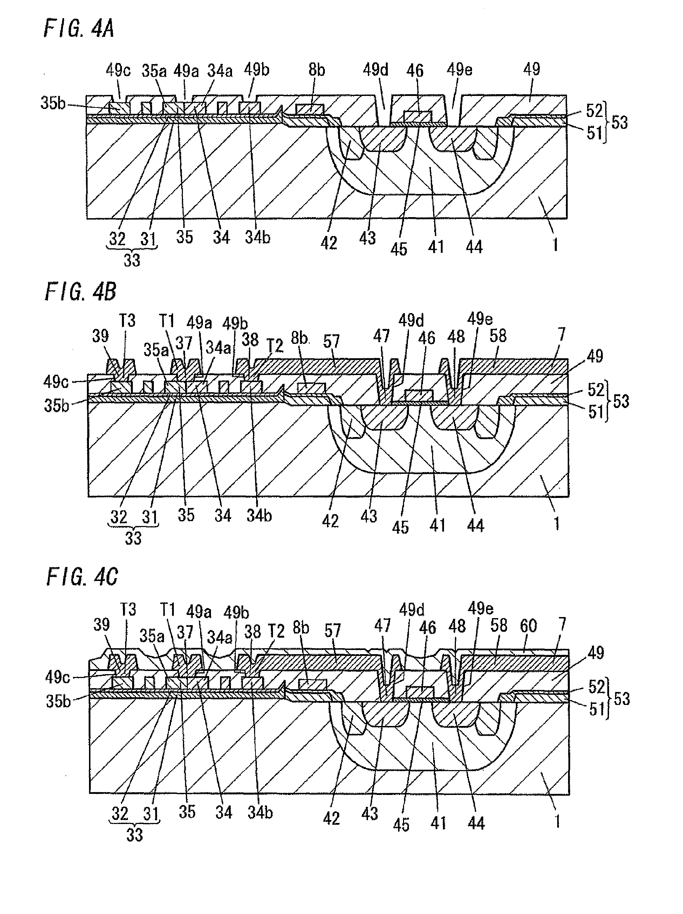

After the gate/source/drain forming step, with performing the interlayer dielectric film forming step followed by the contact hole forming step, a structure illustrated in FIG. **4A** is obtained.

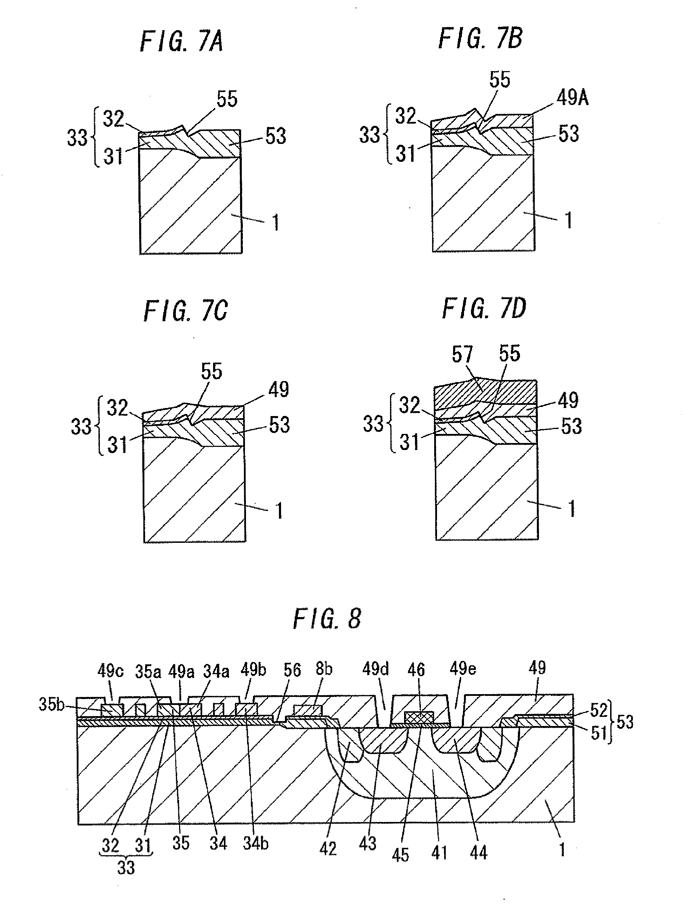

The interlayer dielectric film forming step is defined to form the interlayer dielectric film **49** over the surface of the silicon substrate **1.** Especially, in the interlayer dielectric film forming step, the planarized interlayer dielectric film **49** (see FIG. 7C) is formed by depositing a BPSG film **49A** (see FIG. **7B)** having a predetermined film thickness (e.g., 6500 Å) over the surface of the silicon substrate **1** by use of CVD technique followed by reflowing the deposited BPSG film **49A** at a predetermined temperature (e.g. 800 deg C).

The contact hole forming step is a step of forming the contact holes **49a** to **49e** in the interlayer dielectric film **49** by use of the photolithography technique and the etching technique.

By performing the metal line forming step of forming the metal line **57** designed to connect the temperature detection element **36** with the MOS transistor **4** after the contact hole forming step, a structure illustrated in FIG. 4B is obtained.

The metal line forming step includes a metal film forming step, and a metal film patterning step which is performed after the metal film forming step.

The metal film forming step is defined to form, over the whole of the surface of the silicon substrate **1,** a metal film having a predetermined film thickness (e.g., 1 μm) by use of the sputtering. The above metal film is a base for forming each of the electrodes **37, 38,** and **39,** the drain electrode **47,** the source electrode **48,** each of the metal lines **8a, 57, 58,** and **59,** and the each pad **9.**

The metal film patterning step is defined to pattern the metal film by use of the photolithography technique and the etching technique to form each of the electrodes **37, 38,** and **39,** the drain electrode **47,** the source electrode **48,** each of the metal lines **8a, 57, 58**, and **59,** and the each pad **9.** In the metal film patterning step, the metal film is etched by use of RIE.

By performing the passivation film forming step after the metal film patterning step, a structure illustrated in FIG. 4C is obtained.

The passivation film forming step is defined to form the passivation film **60** over the whole of the surface of the silicon substrate **1** (in other words, on the interlayer dielectric film **49)** by use of CVD technique. The passivation film **60** is a laminated film including a PSG film having a predetermined film thickness (e.g., 0.2 μm) and an NSG film having a predetermined film thickness (e.g., 0.2 μm).

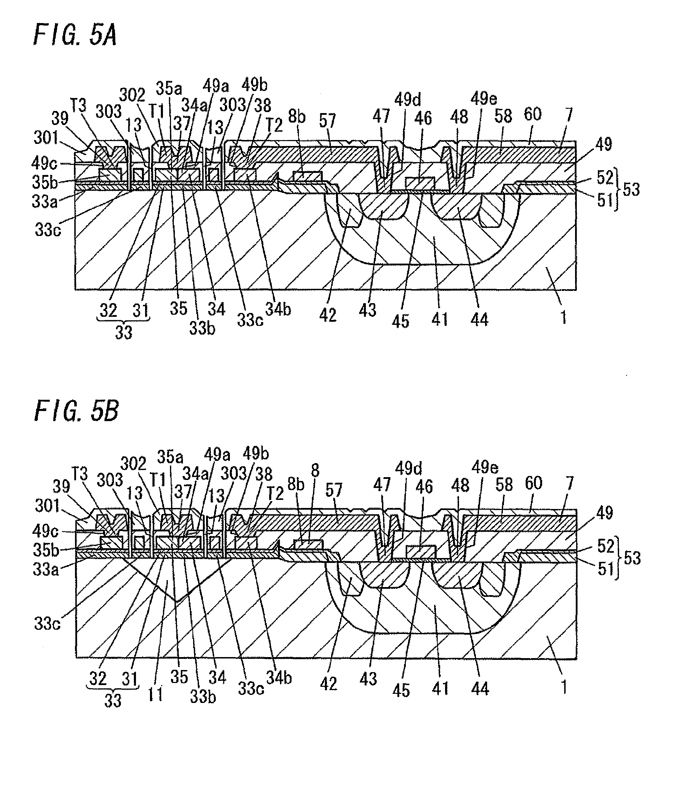

By performing a laminate structure patterning step after the passivation film forming step, a structure illustrated in FIG. 5A is obtained.

The laminate structure patterning step is defined to pattern a laminate (laminate structure) composed of the thermal insulation layer **33,** the temperature detection element **36** formed on the thermal insulation layer **33,** the interlayer dielectric film **49** formed over the thermal insulation layer **33** to cover the temperature detection element **36,** and the passivation film **60** formed on the interlayer dielectric film **49,** thereby forming the infrared detection element **3** (the structure composed of the infrared absorption member **302,** each beam member **303,** and the supporting member **301).** Besides, the laminate structure patterning step includes a step of forming a plurality of slits **13** each of which penetrates the laminate structure along a thickness direction thereof and separates the infrared absorption member **302** from the supporting member **301.** The above structure is completed by forming these slits **13.**

By performing an opening forming step followed by the cavity forming step after the laminate structure patterning step, the infrared image sensor including pixels each having the structure which is illustrated in FIG. 5B is obtained.

The opening forming step is defined to form openings (not shown) by use of the photolithography technique and the etching technique. Each of the openings is designed to expose the corresponding pad **9.** In the opening forming step, the openings are formed by use of RIVE,

The cavity forming step is defined to make anisotropic etching of the silicon substrate **1** by pouring an etchant into the slits **13** and **13** to form the cavity **11** in the silicon substrate **1.** In other words, in the cavity forming step, the slits **13** and **13** are used as an etchant conduit. In the cavity forming step, an alkaline solution (TMAH solution, in the present embodiment) is adopted as the etchant.

Besides, all the steps from the thermal insulation layer forming step to the cavity forming step are performed at wafer level. Therefore, after completion of the cavity forming step, a separation step is made to separate the infrared image sensors from each other.

In addition, as apparent from the above explanation, with regard to a method for forming the MOS transistor **4,** a known and common manufacturing method of MOS transistors is adopted. In other words, with repeat of basic steps (e.g., a step of forming a thermally-oxidized film by use of thermal oxidization, a step of patterning the thermally-oxidized film by use of the photolithography technique and the etching technique, a step of implementing an impurity, and a step of performing drive-in diffusion), the well region **41,** the channel-stopper region **42,** the drain region **43,** and the source region **44** are formed.

As explained in the above, the method for manufacturing the infrared image sensor of the present embodiment includes the thermal insulation layer forming step, the well region forming step, the gate insulation film forming step, the temperature detection element forming step, the drain region and source region forming step, the interlayer dielectric film forming step, the passivation film forming step, and the cavity forming step. The thermal insulation layer forming step is defined as a step of forming the thermal insulation layer **33** over the first area **A1** of the surface of the silicon substrate **1.** The thermal insulation layer **33** includes the silicon dioxide film **31** given compression stress, and the silicon nitride film **32** given tensile stress. The well region forming step after the thermal insulation layer forming step is defined as a step of forming the well region **41** having the first conductivity type (p⁺-type) formed in the second area **A2** of the surface of the silicon substrate. The gate insulation film forming step after the well region forming step is defined as a step of thermally oxidizing the surface of the silicon substrate **1** to form the gate insulation film **45.** The temperature detection element forming step after the gate insulation film forming step is defined as a step of forming, on the thermal insulation layer **33,** the temperature detection element **36** configured to detect a temperature variation. The drain region and source region forming step after the temperature detection element forming step is defined as a step of forming the drain region **43** and the source region **44** within the well region **41.** The interlayer dielectric film forming step after the drain region and source region forming step is defined as a step of forming the interlayer dielectric film **49** over the surface of the silicon substrate **1.** The passivation film forming step after the interlayer dielectric film forming step is defined as a step of forming the passivation film **60** on the interlayer dielectric film **49.** The cavity forming step after the passivation film forming step is defined as a step of forming the cavity **11** in the silicon substrate 1.

In the method for manufacturing the infrared image sensor of the present embodiment, the thermal insulation layer **33** is completed by forming the silicon nitride film **32** on the silicon dioxide film **31** prior to formation of the MOS transistor **4.** In contrast to the silicon dioxide film **31,** the silicon nitride film **32** is hard to be oxidized.

According to the method for manufacturing the infrared image sensor of the present embodiment, although the thermal oxidization is performed in the process of manufacturing the MOS transistor **4,** it is possible to prevent the thermal insulation layer **33** from being thermally oxidized. As a result, the thermal insulation layer **33** can be free from change in at least one of the film thickness and the film configuration. Further, since the thermal insulation layer **33** is completed by forming the silicon nitride film **32** having tensile stress on the silicon dioxide film **31** having compression stress, it is possible to provide the infrared image sensor which is capable of making infrared detection elements thin, yet keeping the infrared absorption member **302** and the respective beam members **301** of the infrared detection element **3** free from warp. Further, in the present embodiment, since a thermoelectric material of the temperature detection element **36** is a polysilicon, the method of the present embodiment suits the method for manufacturing the MOS transistor **4.** Therefore, it is possible to decrease the number of steps of the method for manufacturing the infrared image sensor.

Additionally, in the infrared image sensor of the present embodiment, the silicon nitride film **32** is formed on the surface of the silicon substrate 1 with the exception of the second area **A2** which is used for forming the MOS transistor **4.** Therefore, as described in the above, with adoption of the process of manufacturing the well region **41,** the gate insulation film **45,** the drain region **43,** and the source region **44** of the MOS transistor **4** in subsequence to the formation of the thermal insulation layer **33,** it is possible to prevent the oxidization of the thermal insulation layer **33** which would otherwise occur in the process of manufacturing the MOS transistor **4,** Consequently the thermal insulation layer **33** can be free from change in at least one of the film thickness and the film configuration. Moreover, the thermal insulation layer **33** comprises the silicon dioxide film **31** having a compression stress, and the silicon nitride film **32** having a tensile stress and formed on the silicon dioxide film **31.** Therefore, even if the MOS transistor **4** is formed by use of a common method, it is possible to make the infrared detection element 3 thin, yet keeping it free from warp. Besides, in the infrared image sensor of the present embodiment, the silicon nitride film **32** is not formed on the second area **A2.** However, the silicon nitride film **32** may be formed over the surface of the silicon substrate **1** at a portion at least except for a projected area of the well region **41** of the MOS transistor **4** projected in its thickness direction (i.e., the silicon nitride film may be formed not to be overlapped with the well region **41** in its thickness direction).

In addition, the infrared detection element **3** is formed to satisfy both the following formulae (1) and (2).

[Formula 3]

$$\int_{-1/2}^{1/2} \sigma_m(y)\,dy = 0 \quad (1)$$

[Formula 4]

$$\int_{-1/2}^{1/2} \sigma_m(y) \cdot y\,dy = 0 \quad (2)$$

In the above formulae, y denotes a distance from a center of the infrared detection element **3** along a direction (vertical direction, in FIG. 1 C) aligned with a thickness direction of the infrared detection element **3**, and $s_m(y)$ denotes a stress of the infrared detection element **3**, and t denotes a thickness of the infrared detection element **3**.

In the present embodiment, a formation condition for the infrared detection element **3** is selected to satisfy the formulate (1) and (2). Notably, when the formula (1) is satisfied, it is possible to reduce residual stress of the infrared detection element **3** down to zero. In addition, when the formula (2) is satisfied, it is possible to reduce a bending moment of the infrared detection element **3** down to zero. Therefore, the infrared detection element **3** can be free from warp.

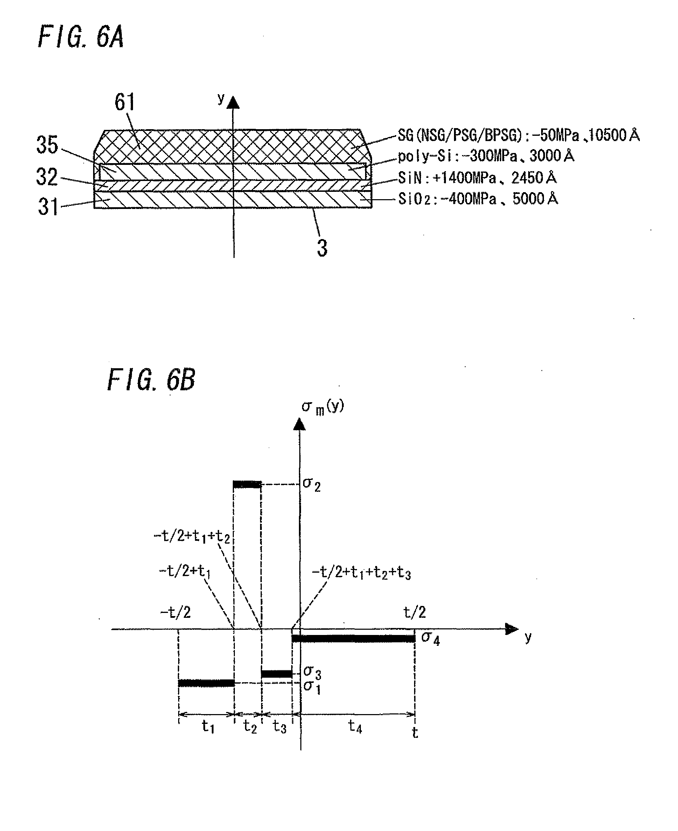

As shown in FIG. 6A, the infrared detection element **3** has a laminated structure in which the silicon dioxide film **31**, the silicon nitride film **32**, the polysilicon layer **35** (or polysilicon layer **34**), and an SG film **61** are laminated in this order. The SG (Silicate Glass) film **61** is a laminated film which comprises the interlayer dielectric film **49** made of the BPSG film and the passivation film **60** made of the NSG film and the PSG film.

Therefore, the above formulae (1) and (2) can be rewritten as the following formulae (3) and (4), respectively. With regard to the following formulae (3) and (4), $s_1(y)$ denotes a stress of the silicon dioxide film **31**, and $s_2(y)$ denotes a stress of the silicon nitride film **32**, and $s_3(y)$ denotes a stress of the polysilicon layer **35**, and $s_4(y)$ denotes a stress of the SG film **61**. Further, $t_1$ denotes a thickness of the silicon dioxide film **31**, and $t_2$ denotes a thickness of the silicon nitride film **32**, and $t_3$ denotes a thickness of the polysilicon layer **35**, and $t_4$ denotes a thickness of the SG film **61**, Further, t satisfies a relation of $t=t_1+t_2+t_3+t_4$.

[Formula 5]

$$\int_{-\frac{1}{2}}^{-\frac{1}{2}+t_1} \sigma_1(y)dy + \int_{-\frac{1}{2}+t_1}^{-\frac{1}{2}+t_1+t_2} \sigma_2(y)dy + \int_{-\frac{1}{2}+t_1+t_2}^{-\frac{1}{2}+t_1+t_2+t_3} \sigma_3(y)dy + \int_{-\frac{1}{2}+t_1+t_2+t_3}^{\frac{1}{2}} \sigma_4(y)dy = 0 \quad (3)$$

[Formula 6]

$$\int_{-\frac{1}{2}}^{-\frac{1}{2}+t_1} \sigma_1(y)\cdot ydy + \int_{-\frac{1}{2}+t_1}^{-\frac{1}{2}+t_1+t_2} \sigma_2(y)\cdot ydy + \int_{-\frac{1}{2}+t_1+t_2}^{-\frac{1}{2}+t_1+t_2+t_3} \sigma_3(y)\cdot ydy + \int_{-\frac{1}{2}+t_1+t_2+t_3}^{\frac{1}{2}} \sigma_4(y)\cdot ydy = 0 \quad (4)$$

Further, the method of manufacturing the infrared image sensor according to the present embodiment has the thermal insulation layer forming step in which the formation temperature (that is, lower one of the formation temperature of the silicon dioxide film **31** and the formation temperature of the silicon nitride film **32**) of the thermal insulation layer **33** is selected to be higher than any process temperature in all the steps performed after the thermal insulation layer forming step (in the present embodiment, the formation temperature of the thermal insulation layer **33** is 1100 deg C). In brief, the method comprises a step of keeping a temperature of the silicon dioxide film **31** less than a temperature required for forming the silicon dioxide film **31** and of keeping a temperature of the silicon nitride film **32** less than a temperature required for forming the silicon nitride film **32**, after the thermal insulation layer forming step. Therefore, each of the silicon dioxide film **31** and the silicon nitride film **32** can retain its thickness and stress free from undesired effect which would be otherwise caused by a process temperature in a subsequent step after the thermal insulation layer forming step. Consequently, the infrared detection element **3** can be successfully free from warp.

With regard to the method for manufacturing the infrared image sensor of the present embodiment, in the well region forming step, as shown in FIG. 7A, the thermally-oxidized film **53**, which is adjacent to the second area **A2**, is formed on the surface of the silicon substrate **1**. This thermally-oxidized film **53** comprises the aforementioned silicon dioxide films **51** and **52**.

As shown in FIG. 7A, a height difference occurs at a border **55** between the thermally-oxidized film 53 and the thermal insulation layer **33**. In other words, a step is developed between the thermally-oxidized film **53** and the thermal insulation layer **33**.

As described in the above, in the interlayer dielectric forming step, as shown in FIG. 7B, the interlayer dielectric film **49** is formed by depositing the BPSG film **49A** over the surface of the silicon substrate **1** followed by reflowing the same. With this manner, it is possible to form the planarized interlayer dielectric film **49** as shown in FIG. 7C. The metal line **57** is formed on the planarized interlayer dielectric film **49**, as shown in FIG. 7D.

Therefore, according to the method of manufacturing the infrared image sensor of the present embodiment, the interlayer dielectric film **49** can have an improved flatness, thereby making the metal line **57** free from partial undue reduction in thickness and therefore avoiding breakage of the metal line, and also avoiding breakage due to an excess thermal stress.

**(SECOND EMBODIMENT)**

The infrared image sensor of the present embodiment is different from the infrared image sensor of the first embodiment in that the infrared image sensor of the present embodiment includes a recess **56.** Besides, configurations to the infrared image sensor of the present embodiment and the infrared image sensor of the first embodiment are designated by the same reference numerals, and no explanations thereof are deemed necessary.

In the method for manufacturing the infrared image sensor of the present embodiment, by performing a recess forming step followed by the interlayer dielectric film forming step after the well region forming step, a structure illustrated in FIG. 8 is obtained.

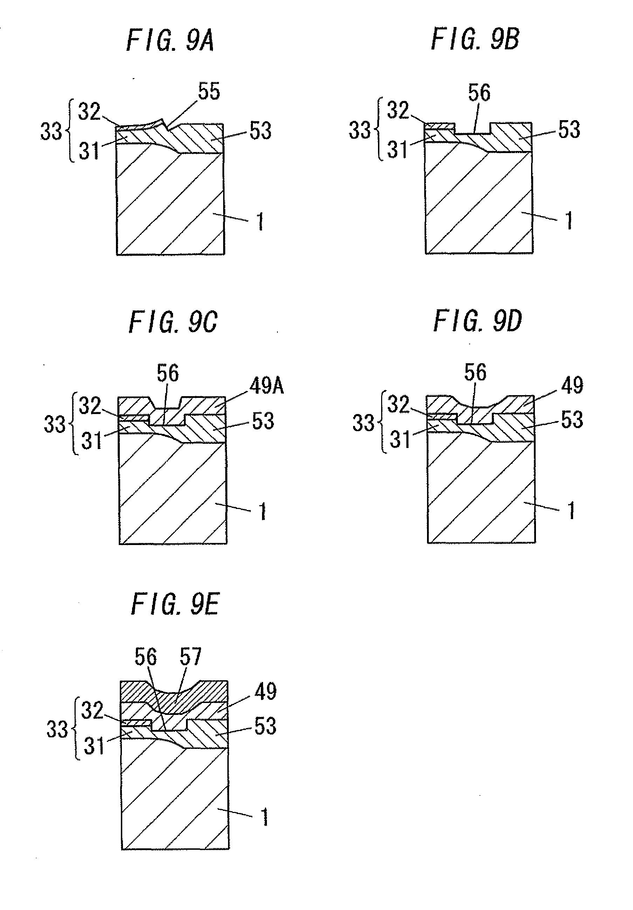

The recess forming step is defined as a step of forming a recess **56** for decreasing the height difference by use of the photolithography technique and the etching technique, as shown in FIG. 9B. The recess **56** is formed in the thermal insulation layer **33** and the thermally-oxidized film 53 along the border 55 (see FIG. 9A). Additionally, the recess **56** is formed to have a depth which is small relative to the height difference between the thermal insulation layer **33** and the thermally-oxidized film **53.**

Like the first embodiment, the interlayer dielectric forming step after the recess forming step is defined as a step of depositing the BPSG film **49A** over the surface of the silicon substrate **1** followed by reflowing of the same as shown in FIG. 9C to form the planarized interlayer dielectric film **49** as shown in FIG. 9D.

By performing the metal line forming step of forming the metal line **57** after the interlayer dielectric film forming step, a structure illustrated in FIG. 9E is obtained.

In the method for manufacturing the infrared image sensor as mentioned in the above, the recess **56** is formed at the border **55** between the thermal insulation layer **33** and the thermally-oxidized film **53** to have a depth which is small relative to the height difference between the thermal insulation layer **33** and the thermally-oxidized film **53** after the well region forming step and before the interlayer dielectric film forming step.

According to the method of manufacturing the infrared image sensor of the present embodiment, the interlayer dielectric film **49** can have a more improved flatness than that of the first embodiment, thereby making the metal line **57** free from partial undue reduction in thickness and therefore successfully avoiding breakage of the metal line, and also successfully avoiding breakage due to an excess thermal stress.

Further, the infrared image sensor of the present embodiment includes the recess **56** formed at the border 55 between the thermal insulation layer **33** and the thermally-oxidized film **53,** the interlayer dielectric film **49** designed to cover the recess **56,** and the metal line 57 formed on the interlayer dielectric film **49.** The interlayer dielectric film **49** is formed by means of reflowing the BPSG film **49A** deposited over the surface of the silicon substrate **1.**

According to the infrared image sensor of the present embodiment, the interlayer dielectric film **49** can have a more improved flatness than that of the first embodiment, thereby making the metal line **57** free from partial undue reduction in thickness and therefore successfully avoiding breakage of the metal line, and also successfully avoiding breakage due to an excess thermal stress.

**Claims**

1.   A method for manufacturing an infrared image sensor, said infrared image sensor comprising:

a silicon substrate; and
a plurality of cells formed over a surface of said silicon substrate,
wherein each of said cells includes an infrared detection element configured to detect an infrared, and a MOS transistor configured to read out an output of said infrared detection element, said MOS transistor being arranged adjacent to said infrared detection element,
said silicon substrate being provided with cavities for thermal insulation in its portions respectively corresponding to said infrared detection elements of said cells,
each of said infrared detection elements including a thermal insulation layer formed over said surface of said silicon substrate, and a temperature detection element formed on said thermal insulation layer,
said thermal insulation layer including a silicon dioxide film for thermal insulation formed on said surface of said silicon substrate, and a silicon nitride film for thermal insulation formed on said silicon dioxide film, said silicon dioxide film having compression stress, said silicon nitride film having tensile stress,
said temperature detection element being configured to absorb infrared and detect temperature change resulting form infrared absorption, and
said MOS transistor including a well region of a first conductivity type formed in said surface of said silicon substrate, a drain region of a second conductivity type formed in said well region, a source region of the second conductivity type formed in said well region so as to be away from said drain region, and a gate insulation film formed on a part of said well region formed between said drain region and said source region, and said method comprising:

a thermal insulation layer forming step of forming said thermal insulation layer over a first area of said surface of said silicon substrate;
a well region forming step of forming said well region formed in a second area of said surface of said silicon substrate after said thermal insulation layer forming step;
a gate insulation film forming step of forming said gate insulation film by means of thermal oxidation of said surface of said silicon substrate after said well region forming step;
a temperature detection element forming step of forming said temperature detection element after said gate insulation film forming step;
a drain region and source region forming step of forming said drain region and said source region after said temperature detection element forming step; and
a cavity forming step of forming said cavity after said drain region and source region forming step.

2. A method for manufacturing the infrared image sensor as set forth in claim 1, wherein said method further comprises:

an interlayer dielectric film forming step of forming an interlayer dielectric film over said surface of said silicon substrate by depositing a BPSG film over said surface of said silicon substrate followed by reflowing the deposited BPSG film, after said drain region and source region forming step and before said cavity forming layer;
a metal line forming step of forming a metal line electrically connecting said temperature detection element with said MOS transistor, after said interlayer dielectric film forming step and before cavity forming step; and
a passivation film forming step of forming a passivation film on said interlayer dielectric film, after said metal line forming step and before said cavity forming step.

3. A method for manufacturing the infrared image sensor as set forth in claim 2, wherein said method further comprises a recess forming step of forming a recess, after said well region forming step and before said interlayer dielectric film forming step,
said well region forming step including a step of forming a thermally-oxidized film on said second area so as to be adjacent to said thermal insulation layer, and
said recess forming step including a step of forming, at a border between said thermal insulation layer and said thermally-oxidized film, said recess having a depth of said recess which is small relative to a height difference between said thermal insulation layer and said thermally-oxidized film.

4. A method for manufacturing the infrared image sensor as set forth in claim 1, wherein said method further comprises a step of forming said infrared detection element to satisfy following two formulae:

$$\int_{-t/2}^{t/2} \sigma_m(y)\,dy = 0$$

$$\int_{-t/2}^{t/2} \sigma_m(y) \cdot y\,dy = 0$$

wherein y denotes a distance from a center of said infrared detection element along a direction aligned with a thickness direction of said infrared detection element, and
$S_m(y)$ denotes a stress of said infrared detection element, and
t denotes a thickness of said infrared detection element.

5. A method for manufacturing the infrared image sensor as set forth in claim 1, further comprising a step of keeping a temperature of said silicon dioxide film less than a temperature required for forming said silicon dioxide film and of keeping a temperature of said silicon nitride film less than a temperature required for forming said silicon nitride film, after said thermal insulation layer forming step.

6. An infrared image sensor comprising:

a silicon substrate; and

a plurality of cells formed over a surface of said silicon substrate,

wherein each of said cells includes an infrared detection element configured to detect an infrared, and a MOS transistor configured to read out an output of said infrared detection element, said MOS transistor being arranged adjacent to said infrared detection element,

said silicon substrate being provided with cavities for thermal insulation in its portions respectively corresponding to said infrared detection elements of said cells,

each of said infrared detection elements including a thermal insulation layer formed over said surface of said silicon substrate, and a temperature detection element formed on said thermal insulation layer,

said thermal insulation layer including a silicon dioxide film for thermal insulation formed on said surface of said silicon substrate, and a silicon nitride film for thermal insulation formed on said silicon dioxide film, said silicon dioxide film having compression stress, said silicon nitride film having tensile stress,

said temperature detection element being configured to absorb infrared and detect temperature change resulting form infrared absorption, and

said MOS transistor including a well region of a first conductivity type formed in said surface of said silicon substrate, a drain region of a second conductivity type formed in said well region, a source region of the second conductivity type formed in said well region so as to be away from said drain region, and a gate insulation film formed on a part of said well region formed between said drain region and said source region, and wherein said silicon nitride film is formed not to be overlapped with said well region in its thickness direction.

7. An infrared image sensor as set forth in claim 6, wherein
said infrared image sensor comprises:

a thermally-oxidized film formed over said surface of said silicon substrate so as to be adjacent to said thermal insulation layer;

an interlayer dielectric film formed over said surface of said silicon substrate so as to cover a border between said thermal insulation layer and said thermally-oxidized film; and

a metal line formed on said interlayer dielectric film so as to connect said temperature detection element with said MOS transistor,

said interlayer dielectric film being formed by means of reflowing a BPSG film deposited over said surface of said silicon substrate.

8. An infrared image sensor as set forth in claim 6, wherein
said infrared image sensor comprises:

a thermally-oxidized film formed over said surface of said silicon substrate so as to be adjacent to said thermal insulation layer;

a recess formed at a border between said thermal insulation layer and said thermally-oxidized film;

an interlayer dielectric film formed over said surface of said silicon substrate so as to cover said recess; and

a metal line formed on said interlayer dielectric film so as to connect said temperature detection element with said MOS transistor,

said interlayer dielectric film being formed by means of reflowing a BPSG film deposited over said surface of said silicon substrate.

EP 2 312 286 A1

FIG. 1A

FIG. 1B

FIG. 1C

FIG. 2

FIG. 3A

FIG. 3B

FIG. 3C

FIG. 4A

FIG. 4B

FIG. 4C

FIG. 5A

FIG. 5B

FIG. 6A

61
35
32
31

y

SG (NSG/PSG/BPSG) : −50MPa 、10500 Å
poly-Si : −300MPa 、3000 Å
SiN : +1400MPa 、2450 Å
SiO₂ : −400MPa 、5000 Å

3

FIG. 6B

$\sigma_m(y)$

$\sigma_2$

$-t/2+t_1+t_2$

$-t/2+t_1$

$-t/2+t_1+t_2+t_3$

$-t/2$

$t/2$

y

$\sigma_4$

$\sigma_3$
$\sigma_1$

$t_1$   $t_2$   $t_3$   $t_4$   t

FIG. 7A

FIG. 7B

FIG. 7C

FIG. 7D

FIG. 8

*FIG. 9A*

*FIG. 9B*

*FIG. 9C*

*FIG. 9D*

*FIG. 9E*

## INTERNATIONAL SEARCH REPORT

| International application No. |
|---|
| PCT/JP2009/063241 |

| A. CLASSIFICATION OF SUBJECT MATTER |
|---|
| *G01J1/02*(2006.01)i, *H01L27/14*(2006.01)i, *H01L35/32*(2006.01)i, *H01L35/34* (2006.01)i |
| According to International Patent Classification (IPC) or to both national classification and IPC |

| B. FIELDS SEARCHED |
|---|
| Minimum documentation searched (classification system followed by classification symbols) |
| G01J1/00-1/60, H01L27/14, H01L35/32, H01L35/34, G01J5/02, G01J5/12 |
| Documentation searched other than minimum documentation to the extent that such documents are included in the fields searched |
| Jitsuyo Shinan Koho   1922-1996   Jitsuyo Shinan Toroku Koho   1996-2009 Kokai Jitsuyo Shinan Koho   1971-2009   Toroku Jitsuyo Shinan Koho   1994-2009 |
| Electronic data base consulted during the international search (name of data base and, where practicable, search terms used) |

### C. DOCUMENTS CONSIDERED TO BE RELEVANT

| Category* | Citation of document, with indication, where appropriate, of the relevant passages | Relevant to claim No. |
|---|---|---|
| Y A | JP 2002-124708 A (Matsushita Electric Industrial Co., Ltd.), 26 April, 2002 (26.04.02), Par. Nos. [0001] to [0033]; Figs. 31 to 43 (Family: none) | 6-7 1-5,8 |
| Y | JP 2006-170937 A (Nissan Motor Co., Ltd.), 29 June, 2006 (29.06.06), Full text; all drawings (Family: none) | 6-7 |
| Y | JP 10-239151 A (Matsushita Electric Works, Ltd.), 11 September, 1998 (11.09.98), Full text; all drawings (Family: none) | 6-7 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 13 August, 2009 (13.08.09) | 25 August, 2009 (25.08.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/063241

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-043148 A (Toshiba Corp.), 17 February, 2005 (17.02.05), Par. Nos. [0037] to [0048]; Figs. 7 to 23 (Family: none) | 1-8 |
| A | JP 04-356979 A (Matsushita Electric Works, Ltd.), 10 December, 1992 (10.12.92), Full text; all drawings (Family: none) | 1-8 |
| A | JP 2000-097765 A (Matsushita Electric Works, Ltd.), 07 April, 2000 (07.04.00), Par. Nos. [0038] to [0040]; Fig. 4 (Family: none) | 1-8 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006170937 A